# EUROPÄISCHE PATENTANMELDUNG

(11) **EP 2 367 206 A2**
(43) Veröffentlichungstag der Anmeldung: **21.09.2011**
(21) Anmeldenummer: 11158192.2
(22) Anmeldetag: 15.03.2011
(51) Int. Cl.: H01L 31/02, H01L 31/042, H02H 5/04

(54) **Schutzschaltung für eine Photovoltaikanlage**

(30) Priorität: 15.03.2010 DE 202010003613 U
(71) Anmelder: voltwerk electronics GmbH, 20537 Hamburg (DE)
(72) Erfinder: Knaup, Peter, 64673, Zwingenberg (DE); Thomas, Lenz, 61352, Bad Homburg (DE)
(74) Vertreter: Eisenführ, Speiser & Partner

(57) **Zusammenfassung**

Die Erfindung betrifft eine Photovoltaikanlage, mit einem wenigstens eine Solarzelle aufweisenden Solarmodul zum Wandeln von Licht in elektrische Energie, wenigstens einem Thermoschutzschalter, der ausgebildet ist in der Photovoltaikanlage im Falle eines Brandes und/oder im Falle einer gegenüber einer üblichen Betriebstemperatur signifikant erhöhten oberhalb eines vorbestimmten Grenzwertes auftretenden Übertemperatur, und dadurch gekennzeichnet, dass der wenigstens eine Thermoschutzschalter dem wenigstens einen Solarmodul zugeordnet ist zum Erwirken einer elektrischen Abschaltung oder Spannungsfreischaltung und/oder Abschaltung oder Reduzierung wenigstens einer Klemmenspannung am elektrischen Ausgang des Solarmoduls oder der wenigstens einen Solarzelle des Solarmoduls, im Falle des Brandes oder der Übertemperatur.

## Beschreibung

Die vorliegende Erfindung betrifft eine Photovoltaikanlage gemäß dem Oberbegriff des Anspruchs 1. Weiterhin betrifft die vorliegende Erfindung ein Verfahren zum Steuern einer Photovoltaikanlage einschließlich Überwachen einer Überhitzung wenigstens eines Teils der Photovoltaikanlage. Zudem betrifft die Erfindung ein Gebäude mit einer Photovoltaikanlage.

Photovoltaikanlagen sind allgemein bekannt. Sie umfassen wenigstens ein Solarmodul mit wenigstens einer Solarzelle zum Wandeln von Licht in elektrische Energie. Als Brandschutzmittel kann ein Thermoschutzschalter vorgesehen sein, der die Photovoltaikanlage im Falle eines Brandes abschaltet. Ein solches Abschalten erfolgt beispielsweise temperaturabhängig. Hierbei wird eine Unterbrechung elektrischer Verbindungsleitungen zwischen den Modulen oder zu einer zentralen Schalteinheit, insbesondere eines zentralen Wechselrichters vorgenommen. Außerdem wird die Potovoltaikanlage und damit ein etwaiger Wechselrichter von einem elektrischen Netz, in das die Photovoltaikanlage ansonsten einspeist, getrennt.

Hierdurch wird der Stromfluss unterbrochen, so dass die Photovoltaikanlage keine Leistung mehr umsetzt. Etwaige Überhitzungen durch Überbelastung werden vermieden.

Trotz einer solchen Abschaltung sind die Solarzellen aber weiterhin etwaiger Sonneneinstrahlung ausgesetzt und erzeugen eine entsprechende Spannung. Die elektrische Spannung wird zwar im Falle der beschriebenen Abschaltung nicht in Leistung umgesetzt, gleichwohl können die erzeugten Spannungen jedes Solarmoduls einen hohen Wert aufweisen. Im Falle einer Reihenschaltung mehrerer Solarmodule addieren sich diese Spannungen und können lebensgefährliche Werte erreichen. Dies ist insbesondere im Falle eines Brandes eine Gefahr für Löschkräfte.

Der vorliegenden Erfindung liegt somit die Aufgabe zugrunde, eine Lösung oder Verbesserung für wenigstens eines der oben genannten Probleme vorzuschlagen. Insbesondere soll eine Photovolktaikanlage sowie ein Verfahren zum Steuern vorgeschlagen werden, die gegenüber dem Stand der Technik erhöhte Sicherheit im Brandfalle oder beim Vorbeugen eines Brandes ermöglicht. Zumindest soll eine alternative Lösung vorgeschlagen werden.

Erfindungsgemäß wird eine Photovoltaikanlage gemäß Anspruch 1 vorgeschlagen.

Eine solche Photovoltaikanlage weist wenigstens ein Solarmodul mit wenigstens einer Solarzelle zum Wandeln von Licht in elektrische Energie auf. Es ist wenigstens ein Thermoschutzschalter vorgesehen, der dazu vorbereitet ist, eine elektrische Abschaltung oder spannungsfreie Schaltung wenigstens eines Teils der Photovoltaikanlage zu erreichen und/oder der dazu vorbereitet ist, wenigstens eine Klemmenspannung in der Photovoltaikanlage abzuschalten oder zu reduzieren, wenn ein Brand auftritt oder wenn eine Übertemperatur auftritt. Als Übertemperatur wird in diesem Sinne eine Temperatur an einer Stelle der Photovoltaikanlage angesehen, die höher ist, als eine übliche, insbesondere als eine zulässige Betriebstemperatur an derselben Stelle. Zum Festlegen einer solchen Abschaltung wird ein vorbestimmter Grenzwert der betreffenden Temperatur vorgegeben. Dieser Grenzwert liegt über der üblichen Betriebstemperatur an der betreffenden Stelle und kann bis zu einem Wert gewählt werden, der einem Brandfall in dem betreffenden Bereich entspricht.

Der Thermoschutzschalter ist dem wenigstens einen Solarmodul zugeordnet, nämlich insbesondere in seiner Nähe und/oder in der Nähe oder an einem elektrischen Ausgang des Solarmoduls angeordnet, um einen elektrischen Ausgang des Solarmoduls oder der wenigstens einen Solarzelle des Solarmoduls spannungsfrei zu schalten oder kurzzuschließen, wenn ein Brand oder zumindest eine Übertemperatur auftritt. Wenn mehrere Solarmodule vorgesehen sind, soll jedem Solarmodul jeweils wenigstens ein Thermoschutzschalter zugeordnet werden.

Der Thermoschutzschalter schaltet somit im Brandfall oder bei Übertemperatur den Ausgang des betreffenden Solarmoduls spannungsfrei oder schließt ihn kurz. Es wird somit nicht nur oder nicht hauptsächlich eine Leistungsabschaltung der Photovoltaikanlage durchgeführt, sondern die Spannung des Ausgangs des Solarmoduls, insbesondere seine Klemmenspannung, also die Spannung zwischen zwei Klemmen, auf null reduziert. Damit wird insbesondere die Gefahr eines elektrischen Schlags durch Spannung am Ausgang des Solarmoduls begegnet.

Vorzugsweise erfolgt ein Spannungsfreischalten oder Kurzschließen am Ausgang jedes Solarmoduls. Damit wird zudem auch eine Spannungsaddition in Reihe geschalteter Solarmodule im Brandfalle bzw. bei signifikanter Übertemperatur vermieden.

Durch dieses Spannungsfreischalten oder Kurzschließen erhöht sich insbesondere die Sicherheit von Löschkräften, was wiederum einen Löscheinsatz begünstigt. Im Ergebnis wird ein Brandrisiko oder zumindest die Auswirkungen eines Brandes reduziert.

Vorzugsweise ist ein Thermoschutzschalter mit dem jeweils zugeordneten Solarmodul so verschaltet, dass er im Falle des Brandes oder der Übertemperatur den elektrischen Ausgang des Solarmoduls kurzschließt und/oder wenigstens einen Anschlusspunkt des elektrischen Ausgangs erdet. Das Kurzschließen des Ausgangs des Solarmmoduls führt einerseits unmittelbar zu einer Spannungsabschaltung an dem betreffenden Ausgang, insbesondere an entsprechenden Anschlussklemmen. Zudem bricht aber auch die Spannung des betreffenden Solarmoduls und damit der Solarzelle bzw. Solarzellen zusammen. Im Ergebnis treten an keiner Stelle des Solarmoduls nach einem solchen Kurzschließen mehr nennenswerte Spannungen auf. Durch das Zusammenbrechen der Zellenspannungen bricht auch die erzeugte bzw. erzeugbare Leistung zusammen.

Durch ein Erden wenigstens eines Anschlusspunktes ist jedenfalls dieser Anschlusspunkt auch absolut in Bezug auf Erdpotential spannungsfrei. Bei Erdung zweier Anschlusspunkte, sind diese in Bezug auf das Erdpotential und auch zueinander spannungsfrei. Hierdurch kann ein hohes Maß an Sicherheit erreicht werden.

Eine der vorliegenden Erfindung zugrunde liegende Photovoltaikanlage weist üblicherweise - wenngleich dies nicht beschränkend ist - mehrere Solarmodule mit jeweils mehreren Solarzellen auf. Eine Solarzelle ist im Grunde ein entsprechender Halbleiterwafer, beispielsweise ein Si-Wafer, der mit Anschlusskontakten versehen und gegebenenfalls einen mechanisch stabilisierenden Aufbau, wie einen Rahmen, gegeben ist. Mehrere solcher Solarzellen werden zu einem Solarmodul verschaltet. Die Solarzellen können hierbei parallel, in Reihe oder kombiniert parallel und in Reihe geschaltet sein. Das hängt von den elektrischen Eigenschaften der Solarzelle ab und der gewünschten Ausgangsspannung und des gewünschten Ausgangsstroms des Solarmoduls. Mehrere Solarmodule können parallel, in Reihe oder kombiniert parallel und in Reihe zu einer Photovoltaikanlage verschaltet sein, wobei die Photovoltaikanlage weitere Komponenten aufweist, wie beispielsweise eine Steuereinheit und/oder eine Einspeiseeinheit zum Einspeisen der erzeugten elektrischen Energie. Ein aus mehreren Solarzellen zusammengesetztes Solarmodul bildet üblicherweise eine kompakte, in einem Rahmen verbundene Einheit. Mehrere zu einer Photovoltaikanlage verschaltete Solarmodule sind oftmals zumindest mit einem geringen Abstand örtlich voneinander getrennt und beispielsweise nebeneinander auf einer gemeinsamen Tragkonstruktion oder verteilt auf mehrere Tragkonstruktionen aufgestellt. Die Verschaltung der Solarmodule zu einer Photovoltaikanlage erfolgt dann über entsprechende Anschlussleitungen zum Verbinden der Solarmodule.

Vorzugsweise weist jedes Solarmodul einer Photovoltaikanlage eine die jeweiligen elektrischen Ausgänge aufnehmende Anschlussdose auf. In oder an jeder Anschlussdose ist wenigstens ein Thermoschutzschalter so angeordnet und verschaltet, dass im Falle des Brandes oder der Übertemperatur jeweils der elektrische Ausgang innerhalb der Anschlussdose spannungsfrei geschaltet und/oder kurzgeschlossen wird.

Vorzugsweise werden die elektrischen Anschlüsse innerhalb der Anschlussdose kurzgeschlossen. Hierdurch bricht die Spannung des Solarmoduls zusammen, was sich auf die Spannung der Anschlüsse in der Anschlussdose entsprechend auswirkt.. Das Kurzschließen stellt somit eine einfache und wirkungsvolle Variante dar.

Eine weitere bevorzugte Ausführungsform schlägt vor, wenigstens zwei Thermoschutzschalter vorzusehen. Einer der Thermoschutzschalter ist dabei als Brandschutzschalter ausgebildet, um den elektrischen Ausgang im Falle des Brandes spannungsfrei zu schalten und/oder kurzzuschließen. Ein weiterer der Thermoschutzschalter ist dazu ausgebildet, im Falle der Übertemperatur den elektrischen Ausgang spannungsfrei zu schalten und/oder kurzzuschließen. Zusätzlich oder alternativ wird durch diesen weiteren Thermoschutzschalter ein Warnsignal ausgelöst, um einen Brand zu verhindern. Der Brandschutzschalter ist dabei dazu ausgebildet, bei einer höheren Temperatur auszulösen, als der Brandwarnschalter. Insoweit kann der Brandwarnschalter eher als eine Präventivschutzvorrichtung angesehen werden, wohingegen der Brandschutzschalter aktiv wird, wenn bereits ein Brandfall vorliegt. Durch den Brandschutzschalter sollen somit im Brandfall weitere Schäden oder Gefährdung von Personen verhindert werden.

Das Warnsignal, das durch den Brandwarnschalter ausgelöst wird, kann sowohl ein akustisches und/oder optisches Signal zum Alarmieren von Personen sein oder es kann alternativ oder zusätzlich ein automatisch auswertbares Signal sein, wie beispielsweise ein Signal, das an einen Mikroprozessor gesendet wird, um dadurch weitere Aktivitäten wie beispielsweise das Abschalten der gesamten Photovoltaikanlage auszulösen.

Vorzugsweise ist der Brandschutzschalter irreversibel auslösend zum einmaligen Gebrauch ausgebildet. Der Brandwarnschalter ist vorzugsweise reversibel auslösend als mehrfach verwendbarer Schalter ausgebildet. Damit steht für den Brandschutzschalter die Sicherheit für Personen und Gegenstände im Vordergrund. Durch das irreversible Auslösen wird verhindert, dass ein Wiedereinschalten ungewollt erfolgt. Der Brandwarnschalter, der bei niedrigeren Temperaturen auslöst als der Brandschutzschalter, sollte nach einem Auslösen wieder zurückgesetzt werden können, was insbesondere im Anschluss an eine Fehlerbehebung vorgesehen ist.

Vorzugsweise ist bei einer Photovoltaikanlage für jedes Solarmodul sowohl ein Brandschutzschalter als auch ein Brandwarnschalter vorgesehen.

Gemäß einer Ausgestaltung wird vorgeschlagen, dass der Brandschutzschalter ein Schmelzelement zum Schmelzen im Falle des Brandes aufweist, um durch das Schmelzen einen irreversiblen Schaltvorgang auszulösen. Somit führt eine einem Brand zuzuordnende Temperatur an dem Brandschutzschalter zu einem irreversiblen Auslösen, bei dem ein technisches Versagen des Auslösens ausgeschlossen oder zumindest minimiert ist.

Für den Brandwarnschalter kann ein sich unter thermischer Einwirkung verformendes, insbesondere vorgespanntes, vorzugsweise ein ein Bimetall umfassendes Element vorgesehen sein, um im Falle der Übertemperatur durch das Verformen einen reversiblen Schaltvorgang auszulösen. Beim Auftreten einer entsprechend hohen Temperatur, die aber noch unter der eines üblichen Brandes liegt, erfolgt somit ein Auslösen durch das Verformen. Ein Spannungsfreischalten und/oder Kurzschließen und/oder das Ausgeben eines Warnsignals wird hierdurch ausgelöst. Sinkt die Temperatur aber wieder ab, so kann das Auslösen wieder rückgängig gemacht werden. Die Photovoltaikanlage kann somit normal weiterbetrieben werden, wenn die Temperatur wieder sinkt und kein Brandfall vorlag. Falls doch ein Brandfall vorlag, so wäre ein Auslösen durch den Brandschutzschalter zu erwarten.

Gemäß einer weiteren Ausführungsform umfasst die Photovoltaikanlage eine Steuereinheit, die insbesondere mit einem Wechselrichter zum Wandeln einer von den Solarmodulen gelieferten Gleichspannung in eine Wechselspannung ausgestattet ist. Vorzugsweise ist der Wechselrichter zum Einspeisen elektrischer Energie in ein elektrisches Netz ausgebildet. Die Steuereinheit ist dazu vorbereitet, das Auslösen wenigstens eines der Thermoschalter zu detektieren und die Photovoltaikanlage oder einen Teil davon abzuschalten, kurzzuschließen, spannungsfrei zu schalten und/oder an wenigstens einem elektrischen Anschlusspunkt zu erden und/oder einen Alarm auszulösen. Somit kann zum einen ein Schutz durch das Schalten der betreffenden Thermoschutzschalter als solcher erreicht werden und zusätzlich wird das Schaltverhalten des bzw. der Thermoschutzschalter in der Steuereinheit ausgewertet, um gegebenenfalls weitere Schutzmaßnahmen einzuleiten.

Das Schalten eines Thermoschutzschalters kann unmittelbar durch Überwachen des Schalters oder indirekt durch Erkennen von Strom- und/oder Spannungsänderungen in der Photovoltaikanlage erfasst werden. Vorzugsweise ist die Steuereinheit dazu ausgebildet, einen Kurzschluss oder einen Erdschluss zu erkennen. Ein Kurzschluss kann beispielsweise durch einen sprunghaften Spannungsabfall und/oder einen sprunghaften Stromabfall erkannt werden. Sind mehrere Solarmodule in Reihe geschaltet und betrifft der Kurzschluss nur ein Solarmodul, so erfolgt ein sprunghafter Spannungsabfall, wobei die gesamte Spannung aller Solarmodule, die bei der Steuereinheit anliegen, für diesen Fall nur reduziert wird, nicht aber auf null abfällt. Außerdem wird in diesem Fall durch den Kurzschluss der Stromkreis der Photovoltaikanlage nicht unterbrochen, so dass weiterhin ein Strom fließt. Die Amplitude des Stromes der Photovoltaikanlage kann hierbei im Wesentlichen unverändert bleiben.

Im Falle des Erdens wenigstens eines Anschlusspunktes eines Solarmoduls wird zumindest ein Teil des Stroms der Photovoltaikanlage in die Erde abgeleitet. Eine entsprechende Stromänderung kann an der Steuereinheit erfasst werden. Insbesondere kann dies zu einer Stromdifferenz an zwei Anschlusspunkten bei der Steuereinheit führen und ein entsprechender Differenzstrom als Fehlerstrom erkannt werden. Hierdurch ist auf einfache Weise ein Erdschluss detektierbar und die Photovoltaikanlage kann vorsorglich abgeschaltet werden. Ein solches Abschalten betrifft beispielsweise einen Wechselrichter, der zum Einspeisen in ein Netz vorgesehen ist. In diesem Fall wird das Einspeisen unterbrochen und von den Solarmodulen wird dann keine Energie mehr abgenommen.

Gemäß einer weiteren Ausführungsform wird vorgeschlagen, dass wenigstens einer der Thermoschutzschalter eine Signaleinheit aufweist, um einen ausgelösten Zustand des Thermoschutzschalters anzuzeigen und/oder um im Falle des Auslösens des Schutzschalters ein das Auslösen anzeigendes Signal zu senden. Demgemäß wird eine dem Thermoschutzschalter, insbesondere jeweils jedem Thermoschutzschalter örtlich zugeordnete Signaleinheit vorgeschlagen. Erfolgt beispielsweise das Auslösen eines Thermoschutzschalters bei einer großen Photovoltaikanlage, die eine Vielzahl von Solarmodulen umfasst und kann ein Brand vermieden oder zumindest wieder eingedämmt werden, so ist im Anschluss eine Fehlersuche an der Photovoltaikanlage durchzuführen. Durch die Signaleinheit oder Einheiten können diejenigen Solarmodule leicht identifiziert werden, bei denen eine Auslösung der Thermoschutzschalter stattgefunden hat.

Erfindungsgemäß wird zudem ein Verfahren vorgeschlagen, das eine Photovoltaikanlage wie oben beschrieben steuert. Vorzugsweise umfasst ein solches Verfahren wenigstens einen der folgenden Schritte:
1. Kurzschließen und/oder Erden eines Spannungsausgangs eines Solarmoduls im Falle eines Brandes und/oder im Falle einer Übertemperatur.
2. Erfassen des Auslösens eines der Thermoschutzschalter.
3. Auslösen eines Alarms und/oder Abschalten der Photovoltaikanlage, wenn das Auslösen eines Thermoschutzschalters erfasst wird.
4. Überprüfen eines Fehlerstroms des erzeugten Stroms, um einen Erdschluss eines der Solarmodule zu erfassen.

Außerdem wird vorgeschlagen, eine Photovoltaikanlage gemäß der Erfindung als Brandmelder zum Melden eines Brandes und/oder einer Brandgefahr zu verwenden. Häufig wird eine Photovoltaikanlage auf einem Gebäude, wie einer Halle oder auch einem Wohnhaus angebracht. Wird eine Photovoltaikanlage verwendet, die wenigstens eine der beschriebenen Brandschutz und/oder Brandwarneinrichtungen aufweist, so kann hierdurch nicht nur die Photovoltaikanlage sondern auch das Gebäude und/oder Wohnhaus als solches besser geschützt werden oder ein Brand schneller gemeldet werden.

Besonders vorteilhaft ist somit auch ein Gebäude, das mit einer erfindungsgemäßen Photovoltaikanlage ausgestattet ist.

Die Erfindung wird nachfolgend anhand einiger Ausführungsbeispiele exemplarisch unter Bezugnahme auf die begleitenden Figuren näher erläutert.
- Figur 1: zeigt schematisch eine Photovoltaikanlage mit mehreren Solarmodulen und einer Steuereinheit gemäß der Erfindung.
- Figur 2: zeigt schematisch eine erfindungsgemäße Schaltanordnung einer Anschlussdose eines Solarmoduls.
- Figur 3: zeigt die Schaltanordnung der Figur 2 in einem kurzgeschlossenen und geerdeten Zustand.
- Figuren 4 bis 7: zeigen schematisch weitere Ausführungsformen für eine Verschaltung einer Anschlussdose eines Solarmoduls.

Nachfolgend können gleiche Bezugszeichen ähnliche Elemente unterschiedlicher Ausführungsformen bezeichnen.

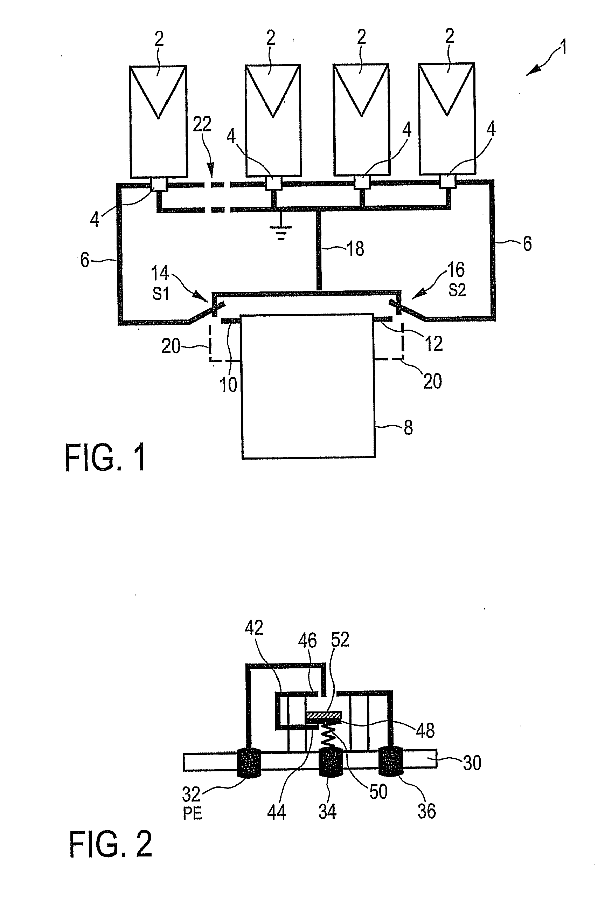

Figur 1 zeigt eine Photovoltaikanlage 1 mit exemplarisch vier Solarmodulen 2 mit jeweils einer Anschlussdose 4. Die vier Solarmodule 2 sind mittels ihrer Anschlussdosen 4 über eine Anschlussleitung 6 in Reihe geschaltet. Die Anschlussleitung 6 führt schließlich zu einer Steuereinheit 8, die einen Wechselrichter, Anschlusskasten oder Gleichstromsteller (DC-Steller) beinhaltet oder ansteuert. Für den Normalbetrieb ist die Anschlussleitung 6 an einem ersten und zweiten Anschlusspunkt 10, 12 an die Steuereinheit 8 angeschlossen.

An dem ersten und zweiten Anschlusspunkt 10, 12 ist ein erster bzw. zweiter Schalter 14, 16 vorgesehen, der jeweils die Anschlussleitung 6 entweder mit dem ersten bzw. zweiten Anschlusspunkt 10, 12 verbindet, oder mit einer Erdverbindung 18. Diese letzte Schalterstellung zur Verbindung mit der Erdverbindung 18 ist in der Figur 1 dargestellt. Die Schaltung des ersten bzw. zweiten Schalters 14, 16 erfolgt durch ein entsprechendes, von der Steuereinheit 8 ausgesendetes Steuersignal 20, das in der Figur 1 als gestrichelte Linien verdeutlicht ist. Von der Steuereinheit wird zudem ein Erdschluss in wenigstens eine der Anschlussdosen 4 erkannt.

Die Anschlussdosen 4 sind ebenfalls mit der Erdverbindung 18 verbunden und im Falle eines Brandes wird in der jeweiligen Anschlussdose bzw. den Anschlussdosen 4 ein Kurzschluss der jeweiligen Anschlussknoten des Solarmoduls sowie ein Erdschluss mit der Erdverbindung 18 hergestellt. Der Vollständigkeit halber wird noch darauf hingewiesen, dass die Anschlussleitung 6 und die Erdverbindung 18 durch eine zeichnerische Unterbrechung 22 die Möglichkeit veranschaulichen, dass eine Vielzahl weiterer Solarmodule 2 vorgesehen sein kann.

Figur 2 verdeutlicht eine Verschaltungsvariante einer Anschlussdose wie einer Anschlussdose 4 der Figur 1. Gemäß Figur 2 ist ein Gehäuseteil 30, das einen Erdanschluss bzw. PE-Anschluss 32 sowie einen ersten und zweiten Gleichstromanschluss 34, 36 aufweist. Der erste und zweite Gleichstromanschluss 34, 36 ist mit einer ersten bzw. zweiten Modulzuleitung elektrisch verbunden. Die ersten und zweiten Modulzuleitungen stellen eine elektrische Verbindung zu den Solarzellen des Moduls her und stellen somit den erzeugten Strom bzw. die erzeugte Spannung in der Anschlussdose bereit. Zum Anschluss mit der ersten Modulzuleitung ist dabei ein Kontaktbügel 42 vorgesehen. Im Normalbetrieb, der in der Figur 2 dargstellt ist, besteht eine elektrische Verbindung zwischen dem ersten Gleichstromanschluss 34 und der ersten Modulzuleitung über einen ersten Kontaktpunkt 44 des Kontaktbügels 42, eine Kontaktplatte 48 und eine elektrisch leitende, vorgespannte Feder 50,die mechanisch mit der Kontaktplatte 48 verbunden ist.

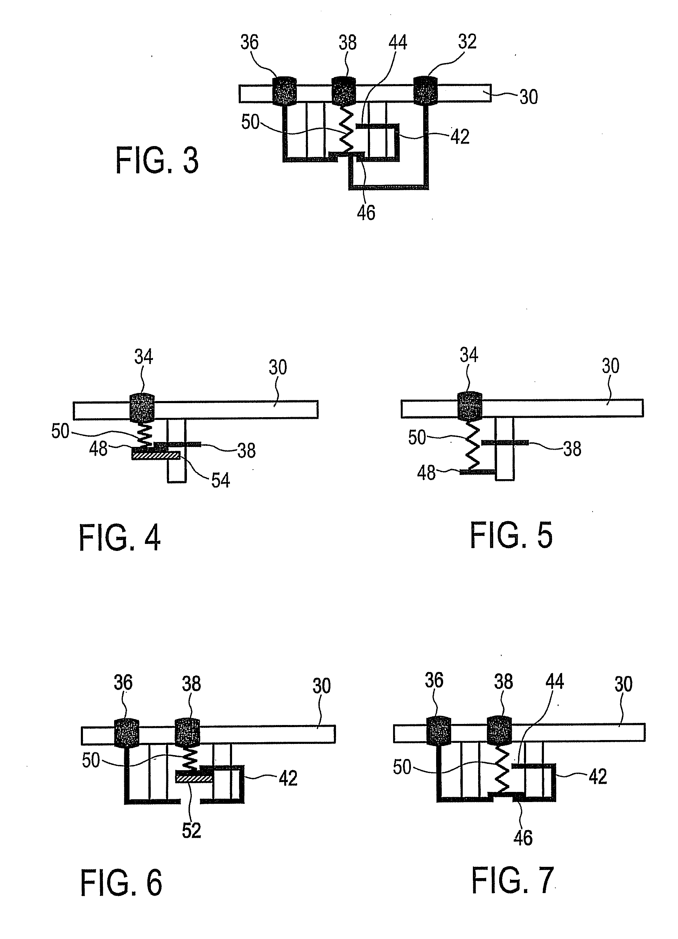

Zwischen der Kontaktplatte 48 und einem zweiten Kontaktpunkt 46 des Kontaktbügels 42 ist ein Schmelzelement 52 aus Kunststoff vorgesehen, das bei Temperaturen, die im Brandfall auftreten, schmilzt. Schmilz das Schmelzelement 52, so wird die Kontaktplatte 48 durch die vorgespannte Feder 50 zum zweiten Kontaktpunkt 46 geschoben und stellt dort eine Verbindung zwischen dem Erdanschluss 32, dem ersten Gleichstromanschluss 34 und dem zweiten Gleichstromanschluss 36 her. Somit sind hierbei beide Anschlüsse des betreffenden Solarmoduls kurzgeschlossen und gleichzeitig auch geerdet. Dieser geschlossene und kurzgeschlossene Zustand ist in der Figur 3 dargestellt.

Figuren 4 und 5 zeigen eine weitere Variante eines Thermoschutzschalters zur Verwendung in der vorliegenden Erfindung, wobei Figur 4 einen normalen Betriebszustand dargestellt und Figur 5 einen ausgelösten Zustand des Thermoschutzschalters. Figuren 4 und 5 zeigen nur einen ersten Gleichstromanschluss 34, der über eine vorgespannte Feder 50 und eine Kontaktplatte 48 einen Kontakt zu einem Modulanschluss 38 herstellt.

Im normalen Betriebszustand hält eine Sicherungseirichtung 54 aus schmelzfähigem Kunststoff die Kontaktplatte 48 in dem in Figur 4 gezeigten Zustand, so dass ein Kontakt von dem ersten Gleichstromanschluss 34 zu dem Kontakt zum Modul 38 hergestellt ist.

Treten nun hohe Temperaturen aufgrund eines Brandes oder aus anderen Gründen auf, so schmilzt diese Sicherungseinrichtung 54 und die Feder 50 bewegt die Kontaktplatte 48 so, dass ein Kontakt zum Modulanschluss 38 geöffnet wird. Hierdurch wird auch der erste Gleichstromanschluss 34 spannungsfrei geschaltet. Dies ist in der Figur 5 dargestellt.

Figuren 6 und 7 veranschaulich einen Aufbau ähnlich der Figur 2 und 3, wobei im Falle des Aufschmelzens des Schmelzelementes 52 jedoch nur ein Kurzschluss zwischen dem ersten und zweiten Gleichstromanschluss 34, 36 erfolgt, ohne dass ein Erdschluss vorgenommen wird.

Die oben beschriebene Erfindung adressiert somit das Problem, dass eine Photovoltaikanlage funktionsbedingt bei Einstrahlung immer unter Spannung steht. Eine thermosensitive Sicherungseinrichtung, die bei Übertemperaturen schmilz, löst einen vorgespannten Kontakt frei, so dass der Kontakt eines Gleichstromanschlusses zum Modul in der Anschlussdose unterbrochen wird und an den Anschlussklemmen keine Spannung mehr anliegt. Bei offenliegenden Anschlüssen des Moduls liegt maximal die Modulspannung an, es erfolgt aber keine Addition der Spannungen weiterer Module, die im Normalfall in Reihe geschaltet sind.

Eine andere Lösung besteht darin, dass durch Auslösen der Sicherungseinrichtung die expandierte Feder einen Kurzschluss an den entsprechenden Modulanschlüssen herstellt und somit die Module kurzschließt. Hiermit wird zudem die Gefahr des Auftretens von Lichtbögen vermieden.

Gemäß einer weiteren Variante kann eine Feder vorgesehen sein, die im normalen Betriebszustand nichtleitend mit einem Gleichstromanschluss verbunden ist. Im Falle einer Auslösung der thermischen Sicherungseinrichtung wird dann ein Kurzschluss des Modulanschlusses hergestellt. Die Feder wird somit erst im Brandfall aktiv und stellt den Kurzschluss zum Abbauen einer Spannung her.

Als weitere Lösung wird im Brandfall neben dem Kurzschluss des Modulanschlusses ein Erdschluss hergestellt, wie in den Figuren 2 und 3 veranschaulicht ist. Dieser ist über den Wechselrichter detektierbar, so dass eine Alarmierung, Abschaltung und gegebenenfalls Kurzschließen des gesamten Generators, also der Gesamtheit der Solarmodule in der Photovoltaikanlage über einen Wechselrichter vorgenommen werden kann.

## Patentansprüche

1. Photovoltaikanlage, mit
- einem wenigstens eine Solarzelle aufweisenden Solarmodul zum Wandeln von Licht in elektrische Energie,
- wenigstens einem Thermoschutzschalter, der ausgebildet ist in der Photovoltaikanlage im Falle eines Brandes und/oder im Falle einer gegenüber einer üblichen Betriebstemperatur signifikant erhöhten oberhalb eines vorbestimmten Grenzwertes auftretenden Übertemperatur, und
**dadurch gekennzeichnet, dass** der wenigstens eine Thermoschutzschalter dem wenigstens einen Solarmodul zugeordnet ist zum Erwirken einer elektrischen Abschaltung oder Spannungsfreischaltung und/oder Abschaltung oder Reduzierung wenigstens einer Klemmenspannung am elektrischen Ausgang des Solarmoduls oder der wenigstens einen Solarzelle des Solarmoduls, im Falle des Brandes oder der Übertemperatur.

2. Photovoltaikanlage nach Anspruch 1, **dadurch gekennzeichnet, dass** mehrere Solarmodule vorgesehen sind und jedem Solarmodul wenigstens ein Thermoschutzschalter zugeordnet ist, insbesondere in seiner Nähe angeordnet ist.

3. Photovoltaikanlage nach Anspruch 1 oder 2, **dadurch gekennzeichnet, dass** wenigstens ein Thermoschutzschalter mit dem jeweils zugeordneten Solarmodul so verschaltet ist, dass er im Falle des Brandes oder der Übertemperatur den elektrischen Ausgang des Solarmoduls kurzschließt und/oder wenigstens einen Anschlusspunkt des elektrischen Ausgangs erdet.

4. Photovoltaikanlage nach einem der vorstehenden Ansprüche, **dadurch gekennzeichnet, dass** jedes Solarmodul eine die jeweiligen elektrischen Ausgänge aufnehmende Anschlussdose aufweist und wenigstens ein Thermoschutzschalter jeweils in oder an der Anschlussdose des Solarmoduls so angeordnet und verschaltet ist, dass im Falle des Brandes oder der Übertemperatur jeweils der elektrische Ausgang innerhalb der Anschlussdose spannungsfrei geschaltet und/oder kurzgeschlossen wird.

5. Photovoltaikanlage nach einem der vorstehenden Ansprüche, **dadurch gekennzeichnet, dass** wenigstens zwei Thermoschutzschalter vorgesehen sind und
- einer der Thermoschutzschalter als Brandschutzschalter ausgebildet ist, um den elektrischen Ausgang im Falle des Brandes spannungsfrei zu schalten und/oder kurzzuschließen , und
- ein weiterer der Thermoschutzschalter als Brandwarnschalter ausgebildet ist, um im Fall der Übertemperatur den elektrischen Ausgang spannungsfrei zu schalten und/oder kurzzuschließen und/oder ein Warnsignal auszulösen, um einen Brand zu verhindern und
der Brandschutzschalter bei einer höheren Temperatur auslöst als der Brandwarnschalter.

6. Photovoltaikanlage nach Anspruch 5, **dadurch gekennzeichnet, dass** der Brandschutzschalter irreversibel auslösend zum einmaligen Gebrauch vorgesehen ist und/oder der Brandwarnschalter reversibel auslösend als mehrfach verwendbarer Schalter ausgebildet ist.

7. Photovoltaikanlage nach Anspruch 5 oder 6, **dadurch gekennzeichnet, dass**
- der Brandschutzschalter ein Schmelzelement zum Schmelzen im Falle des Brandes aufweist, um durch das Schmelzen einen irreversiblen Schaltvorgang auszulösen, und/oder
- der Brandwarnschalter ein sich unter thermischer Einwirkung verformendes, insbesondere vorgespanntes, vorzugsweise ein Bi-Metall umfassendes Element, aufweist, um im Fall der Übertemperatur durch das Verformen einen reversiblen Schaltvorgang auszulösen.

8. Photovoltaikanlage nach einem der vorstehenden Ansprüche, umfassend eine Steuereinheit, insbesondere mit einem Wechselrichter zum Wandeln einer von den Solarmodulen gelieferten Gleichspannung in eine Wechselspannung, wobei die Steuereinheit dazu vorbereitet ist, das Auslösen wenigstens eines der Thermoschalter zu detektieren und die Photovoltaikanlage oder einen Teil davon abzuschalten, kurzzuschließen, spannungsfrei zu schalten und/oder an wenigstens einem elektrischen Anschlusspunkt zu erden und/oder einen Alarm auszulösen.

9. Photovoltaikanlage nach einem der vorstehenden Ansprüche, **dadurch gekennzeichnet, dass** eine bzw. die Steuereinheit dazu vorbereitet ist, einen Kurz- oder Erdschluss wenigstens eines Solarmoduls, insbesondere ausgelöst durch einen Thermoschutzschalter, zu erkennen und die Photovoltaikanlage abzuschalten, kurzzuschließen, spannungsfrei zu schalten und/oder an wenigstens einem elektrischen Anschlusspunkt zu erden und/oder einen Alarm auszulösen.

10. Photovoltaikanlage nach einem der vorstehenden Ansprüche, **dadurch gekennzeichnet, dass** wenigstens einer der Thermoschutzschalter eine Signaleinheit aufweist, um einen ausgelösten Zustand des Thermoschutzschalters anzuzeigen und/oder um im Falle des Auslösens des Schutzschalters ein das Auslösen anzeigendes Signal zu senden

11. Verfahren zum Steuern einer Photovoltaikanlage, umfassend die Schritte
- Wandeln von Licht in elektrische Energie und Erzeugen eines elektrischen Stromes zum Übertragen der elektrischen Energie,
- Überwachen einer Überhitzung, und Abschalten oder Spannungsfreischalten wenigstens eines Teils der Photovoltaikanlage im Falle eines Brandes und/oder im Falle einer gegenüber einer üblichen Betriebstemperatur signifikant erhöhten, oberhalb eines vorbestimmten Grenzwertes auftretenden Übertemperatur,
und der wenigstens eine Thermoschutzschalter ist dem wenigstens einen Solarmodul zugeordnet, und ein elektrischer Ausgang des Solarmoduls oder der wenigstens einen Solarzelle des Solarmoduls, wird im Falle eines Brandes oder einer Übertemperatur spannungsfrei geschaltet und/oder eine Klemmenspannung an dem Ausgang wird abgeschaltet oder reduziert.

12. Verfahren nach Anspruch 11, **gekennzeichnet durch** wenigstens einen der Schritte
- Kurzschließen und/oder Erden eines Spannungsausgangs im Falle eines Brandes und/oder im Falle einer Übertemperatur,
- Erfassen des Auslösens eines der Thermoschutzschalter,
- Auslösen eines Alarms und/oder Abschalten der Photovoltaikanlage, wenn das Auslösen eines Thermoschutzschalters erfasst wird und/oder
- Überprüfen eines Fehlerstroms des erzeugten Stromes, um einen Erdschluss eines der Solarmodule zu erfassen.

13. Verfahren nach Anspruch 11 oder 12, **dadurch gekennzeichnet, dass** eine Photovoltaikanlage nach einem der Ansprüche 1 bis 10 gesteuert wird.

14. Verwendung einer Photovoltaikanlage nach einem der Ansprüche 1 bis 10 als Brandmelder zum Melden eines Brandes und/oder einer Brandgefahr.

15. Gebäude mit einer Photovoltaikanlage nach einem der Ansprüche 1 bis 10.
